# FASCICULE DE BREVET EUROPEEN

(11) **EP 1 981 805 B1**
(45) Date de publication et mention de la délivrance du brevet: **29.09.2010**
(21) Numéro de dépôt: 07731525.7
(22) Date de dépôt: 25.01.2007
(51) Int. Cl.: B81C 1/00

(54) **PROCÉDÉ DE SCELLEMENT À BASSE TEMPÉRATURE D'UNE CAVITÉ SOUS VIDE OU SOUS ATMOSPHÈRE CONTRÔLÉE**
VERFAHREN ZUR NIEDRIGTEMPERATURVERSIEGELUNG EINER KAVITÄT UNTER VAKUUM ODER KONTROLLIERTER ATMOSPHÄRE
METHOD FOR LOW-TEMPERATURE SEALING OF A CAVITY UNDER VACUUM OR UNDER CONTROLLED ATMOSPHERE

(30) Priorité: 08.02.2006 FR 0650445
(43) Date de publication de la demande: 22.10.2008
(73) Titulaire: Commissariat à l'Énergie Atomique et aux Énergies Alternatives, 75015 Paris (FR)
(72) Inventeur: ANDRE, Bernard, F-38950 Quaix en Chartreuse (FR); ARNAUD, Agnès, F-38100 Grenoble (FR)
(74) Mandataire: Vuillermoz, Bruno
(86) Numéro de dépôt international: PCT/FR2007/050697
(87) Numéro de publication internationale: WO 2007/090971

(56) Documents cités:
- US-A1- 2004 248 344
- US-A1- 2005 017 313
- SZE S M: "VLSI Technology Second Edition" 1988, MC GRAW-HILL , SINGAPORE , XP002405624 ISBN: 0-07-100347-9 page 386 - page 393 figure 3

## Description

### DOMAINE TECHNIQUE

L'invention se rapporte au scellement sous vide ou sous atmosphère contrôlée de micro- ou nano-dispositifs, pour lesquels il est nécessaire de maintenir une partie du système sous un vide partiel d'air.

Le procédé décrit dans cette invention consiste à réaliser un dépôt de Germanium (Ge) ou de Silicium (Si) par PVD pour « *Physical Vapor Deposition* » (dépôt physique en phase vapeur).

Ce procédé permet de réaliser un scellement, davantage connue sous l'expression anglo-saxonne « packaging », des éléments actifs au niveau du wafer, c'est à dire de la tranche de matériau semi-conducteur, de façon collective, ce qui permet de baisser de manière significative les coûts de réalisation.

En outre, ce procédé de scellement présente l'avantage de ne pas induire ou de ne pas nécessiter d'élévation significative de température.

Avantageusement, le procédé selon l'invention trouve application dans le domaine des détecteurs infrarouge non refroidis. En effet, la mise en oeuvre d'un tel procédé permet de sceller une cavité sous vide pour améliorer l'isolation thermique du capteur, tout en obtenant un scellement transparent au rayonnement infrarouge.

### ETAT DE LA TECHNIQUE

Comme indiquée précédemment, l'invention vise une technologie de scellement sous vide trouvant des applications dans les nano- ou micro-dispositifs. Sont particulièrement concernés les domaines des MEMS (Micro Electro Mechanical Systems), notamment les micro-résonateurs RF pour les systèmes de communication, nécessitant un facteur de qualité Q élevé. Un tel facteur Q caractérise la sélectivité en fréquence des filtres réalisés et est donc directement lié aux performances des micro-résonateurs. Sous vide, les frottements sont supprimés et le facteur Q s'en trouve considérablement amélioré. Par ailleurs, le vide évite toute contamination des micro-résonateurs, qui induirait un glissement de la fréquence de résonance.

Sont également visés les accéléromètres, les convertisseurs dc-dc micromécaniques et les dispositifs à émission de champ.

Un domaine d'application particulièrement intéressant est celui des détecteurs infrarouge non refroidis. Dans cette application, à la contrainte de sceller une cavité sous vide pour améliorer l'isolation thermique du capteur s'ajoute la nécessité de disposer d'un scellement qui soit transparent au rayonnement infrarouge.

Plusieurs méthodes de scellement de cavités sont connues à ce jour, notamment les méthodes de packaging standard à partir de boîtiers individuels en métal ou en céramique. Malgré les possibilités d'automatisation des procédés, les coûts de tels packaging restent très élevés et parfois rédhibitoires pour certaines applications.

La demande croissante dans le marché des MEMS a conduit à développer des technologies moins coûteuses qui consistent à réaliser le packaging au niveau du wafer lui-même, de façon à bénéficier des effets de traitements collectifs.

Selon cette dernière approche, deux grandes familles de procédés peuvent être distinguées : les procédés dits de « *wafer bonding* » et les procédés de scellement par dépôt sous vide de couches minces.

Les procédés de « *wafer bonding* » consistent, dans leur principe, à placer en contact deux wafers et à les souder par élévation de température. Ces procédés sont complexes à mettre en oeuvre et nécessitent, pour réaliser la soudure, une élévation de température qui peut être critique pour certains dispositifs et autres composants actifs.

La réalisation de dispositifs de taille de plus en plus réduite permet désormais de réaliser des scellements de cavités directement à partir d'un dépôt de couches minces. Ces procédés permettent de baisser les coûts de réalisation car ils ne nécessitent l'adjonction que d'une seule étape dans le procédé de réalisation. La mise sous vide préalable au dépôt assure l'évacuation hors de la cavité à sceller de l'atmosphère ambiante, et le dépôt réalisé bouche les évents, constituant ainsi une barrière étanche.

Les techniques de dépôt utilisées dans l'état antérieur de la technique sont basées sur le principe du dépôt chimique en phase vapeur (CVD, LPCVD, MOCVD...).

Selon ces procédés, un gaz précurseur du dépôt à réaliser est injecté à une pression typiquement comprise entre 10 et 10³ Pa et se décompose sur le substrat à traiter, porté à haute température, typiquement > 400°C **(1).**

Cette technique permet d'obtenir une bonne conformité du dépôt, c'est-à-dire que le dépôt se dépose sur la totalité de la pièce, quelle que soit la géométrie de cette dernière. Pour des passages de marche ou le bouchage d'évent, ceci est un avantage déterminant puisqu'il s'agit de déposer de la matière à la fois au fond et sur les bords du trou à combler.

Toutefois, les inconvénients de la CVD et de ses techniques dérivées, résident dans la température élevée mise en oeuvre, et imposée pour aboutir à la décomposition des précurseurs sur le substrat. Cette température élevée condamne certaines applications où le budget thermique à respecter doit rester le plus faible possible (microbolomètres, applications sur circuit intégré...).

Par ailleurs, les pressions de travail, qui déterminent le niveau de vide dans la cavité, sont de plusieurs décades supérieures à celles mises en oeuvre dans les techniques de dépôt physique en phase vapeur (PVD).

Enfin, les risques de laisser dans la cavité des résidus organiques existent.

Une technique de dépôt alternative est le dépôt physique en phase vapeur (PVD). Selon ce procédé qui se déroule sous vide partiel la vapeur du matériau à déposer est créée par un procédé physique, à savoir par échauffement ou pulvérisation d'une cible. Contrairement aux techniques CVD, la vapeur se condense sur le substrat à traiter, sans nécessiter d'apport thermique supplémentaire.

Toutefois et en pratique, lorsqu'il s'agit d'évaporation, la grande majorité des procédés incluent une étape de chauffage des substrats, en vue de densifier les dépôts et d'améliorer l'adhésion au substrat.

Par ailleurs, il a été observé que les procédés PVD ne permettent pas de réaliser des dépôts conformes, c'est à dire susceptibles d'épouser correctement les formes du substrat. En effet, que ce soit par procédé d'évaporation ou de pulvérisation, la vapeur générée présente une distribution spatiale qui peut être modélisée mathématiquement par une loi en cos(θ)ⁿ, θ étant l'angle entre la direction d'émission de l'atome et l'axe de symétrie de la source émettrice (la perpendiculaire à la cible, dans le cas d'une cible de pulvérisation) et n, un entier qui détermine la forme exacte du nuage de vapeur.

L'émission de la vapeur est donc très dirigée, ce qui affecte de manière importante une bonne conformité de dépôt. De ce fait et jusqu'à présent, les techniques dérivées de la PVD n'ont pas été retenues pour le passage de marche ou le bouchage de trous.

Certaines équipes ont cependant tenté de telles réalisations, mais sans succès.

Ainsi, Stark *et al.* **(2)** revendiquent un scellement sous vide à basse température (T < 250°C). Il s'agit en fait d'un dépôt de nickel réalisé par électrodéposition qui assure un couvercle d'étanchéité. Le scellement final du trou de la cavité a été tenté avec plusieurs méthodes, dont les techniques d'évaporation et de pulvérisation d'or. Dans le cas des techniques de PVD, il a fallu réduire la taille du trou à une valeur de 0,15 µm car le bouchage de trous de dimension supérieure (8 µm) s'est avéré impossible. Ceci constitue une contrainte importante pour la réalisation du dispositif car la réduction de taille de l'évent augmente la durée d'évacuation des gaz de façon importante.

Ce document révèle donc que le bouchage d'évents par évaporation d'or est infructueux. Les auteurs ont choisi, comme stratégie alternative pour le scellement définitif du trou, le soudage de billes d'alliage plomb/étain.

Pour tenter d'éviter l'émission dirigée de la vapeur dans les procédés de PVD et donc la non-conformité du bouchage d'évents, une solution pour l'homme du métier pourrait résider dans le chauffage du substrat. En effet, bien que les espèces aient une forte directivité lors de la phase de transport à l'état gazeux, l'activation thermique du substrat à traiter permet d'augmenter la mobilité des atomes sur la surface et éventuellement d'améliorer la capacité de recouvrement du dépôt. Cependant, comme déjà dit, l'élévation de la température du substrat est fortement défavorable, voire incompatible avec les applications visées par la présente invention.

Une autre alternative qui pourrait être testée est constituée par l'utilisation de porte-substrats inclinés ou orientables, de façon à compenser la directivité de la vapeur par une adaptation de l'angle entre la vapeur et le dispositif à traiter. Cependant, il s'agit d'équipements non conventionnels, peu disponibles dans le milieu industriel, et coûteux. Le document US2005/0017313 décrit la possibilité de sceller les cavités d'un composant à l'aide de l'évaporation sous vide. Une liste de matériaux est proposée, parmi lesquels le silicium et le germanium. Ce document est muet sur les conditions de mise en oeuvre de ce procédé Il existe donc un besoin avéré d'un procédé de scellement par dépôt ne présentant pas les inconvénients mentionnés ci-dessus en rapport avec les procédés de l'état antérieur de la technique, notamment pouvant être mis en oeuvre à basse pression, à basse température, sans précurseur organique ou organo-métallique et dans des dispositifs standardisés de dépôt.

### DESCRIPTION DETAILLEE DE L'INVENTION

Ainsi, l'invention concerne un procédé de scellement d'une cavité d'un échantillon placé dans une enceinte, par dépôt physique en phase vapeur. Selon l'invention et de manière inventive, le dépôt est réalisé par évaporation de Germanium (Ge) ou de Silicium (Si).

Le procédé de dépôt physique en phase vapeur (PVD) est bien connu de l'homme du métier. Il se déroule sous atmosphère raréfié (< 10 Pa) en trois étapes : la création d'une vapeur par évaporation ou pulvérisation à partir d'une source, son transport dans une enceinte et sa condensation à la surface d'un échantillon à revêtir.

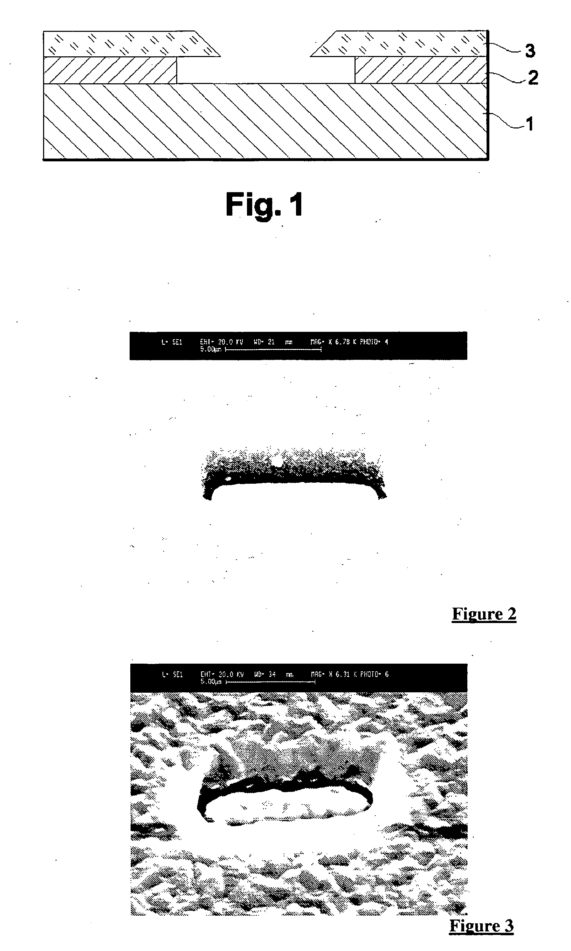

L'invention consiste donc à avoir sélectionné les éléments Ge ou Si pour créer la vapeur par évaporation. Cette sélection est inventive puisque l'état antérieur de la technique a montré que ce procédé n'était pas adapté en utilisant Au **(2)** et il est également montré dans le cadre de l'invention que l'utilisation d'aluminium (Al) ou de sulfure de zinc (ZnS) ne donne pas des résultats satisfaisants (voir Fig. 2, 3 et 4 ci-dessous).

En pratique, le Germanium (Ge) peut se présenter sous forme de morceaux de géométrie quelconque ou de wafer. Le Germanium est placé dans un creuset en cuivre par exemple, ou un liner d'un autre matériau, en molybdène notamment. La vaporisation du Germanium peut être provoquée par un canon à électrons ou un creuset à effet Joule. Dans le cas d'un canon à électrons, les électrons émis par un filament sont accélérés vers le creuset polarisé à des tensions de plusieurs kV, par exemple 8 kV, et provoquent l'échauffement du matériau et son évaporation. Les conditions d'évaporation du Silicium (Si) sont similaires.

De manière remarquable, aucun chauffage intentionnel des échantillons à traiter n'est effectué. Ceci est une différence notoire avec les procédés de l'état antérieur de la technique qui nécessitent une activation thermique.

De ce fait, la température dans l'enceinte demeure inférieure à 100°C, préférentiellement de l'ordre de 20°C. En effet, en l'absence d'échauffement, on peut considérer que la température reste voisine de la température ambiante, autour de 20°C. Un léger échauffement est possible dans le cas où l'enceinte présente de très petites dimensions et la distance creuset-échantillon faible. Quoi qu'il en soit, la température reste toujours inférieure à 100°C.

Comme déjà dit, pour les applications visées, il est déterminant de ne pas induire d'élévation de température lors du procédé de scellement. Ceci présente comme avantage majeur de pouvoir traiter des matériaux sensibles aux élévations de température, notamment les verres et les polymères. Par ailleurs, le Demandeur a montré dans le cadre de cette invention que l'élévation de la température ne suffisait pas à améliorer significativement les résultats de scellement par PVD (voir Fig. 3 ci-dessous).

En termes de pression, l'ensemble du procédé se déroule à basse pression. La pression dans l'enceinte varie avantageusement entre 10⁻⁵ Pa et 10⁻¹ Pa.

Préalablement à l'évaporation, le vide dans l'enceinte est réalisé au moyen d'un groupe de pompage primaire, puis secondaire. Le vide typique avant dépôt est inférieur à 10⁻⁴ Pa.

La pression lors de la phase de dépôt, qui correspond à la pression maximale régnant dans la cavité après scellement, est typiquement comprise entre 10⁻³ et 10⁻⁴ Pa, en l'absence de dégazage de la cavité elle-même.

II est possible d'introduire un gaz dans l'enceinte pour augmenter la pression de travail. Une pression typique est alors de 10⁻¹ Pa.

Un avantage considérable du procédé selon l'invention est qu'il peut être mis en oeuvre dans des dispositifs standard pour la PVD, appelé bâti PVD d'évaporation standard, par exemple de type BALZERS BAK 760.

En outre, des résultats tout à fait satisfaisants ont été obtenus en plaçant l'échantillon à traiter dans l'enceinte sur un porte-échantillon classique, de type calotte. De manière surprenante, il a été montré par le Demandeur que contrairement aux suggestions de l'état antérieur de la technique, l'utilisation d'un porte-échantillon incliné ne permettait pas d'obtenir des résultats satisfaisants dans le cadre des applications visées par la présente invention (voir Fig. 2 et 3 ci-dessous).

Le Germanium et le Silicium utilisés sont suffisamment purs pour être transparents dans l'infrarouge, en particulier dans la gamme spectrale comprise entre 2 et 20 µm. Si le procédé selon l'invention est applicable pour traiter tout nano- ou micro-dispositif, la transparence du scellement obtenu le rend particulièrement adapté lorsque l'échantillon traité est un micro-bolomètre.

Comme déjà dit, le procédé de l'invention permet de réaliser des scellements, bouchages ou encapsulations parfaitement conformes, c'est-à-dire couvrant le fond et les bords des trous à traiter, et présentant l'avantage d'être transparents.

L'invention concerne donc également un échantillon présentant des évents bouchés ou des cavités scellées par dépôt en couches minces de Ge ou de Si.

Avantageusement, un tel échantillon est réalisé en verre ou en polymère, est un nano- ou micro-dispositif, préférentiellement un micro-bolomètre.

### EXEMPLES DE REALISATION

### LEGENDE DES FIGURES

- Figure 1 :: schéma du dispositif de test pour les essais de bouchage d'évents.
- Figure 2 :: vue au microscope électronique à balayage (MEB) du dispositif après dépôt par évaporation à froid d'aluminium (Al) en incidence oblique.
- Figure 3 :: vue au MEB du dispositif après dépôt par évaporation à chaud d'A1 en incidence oblique.
- Figure 4 :: vue au MEB du dispositif après dépôt par évaporation de sulfure de zinc (ZnS) dans un bâti type BAK 760.
- Figure 5 :: vue au MEB du dispositif après dépôt par évaporation de germanium (Ge).

La réalisation de bouchage d'évents par procédé PVD d'évaporation a été testée sur des dispositifs représentatifs d'évents de micro-bolomètre. Le dispositif est représenté sur la figure 1.

Il s'agit d'une plaque de Silicium (Si) **1** sur laquelle 0,3 µm d'oxyde de silicium **2,** puis 1 µm de Si amorphe **3** ont été déposés. L'oxyde est gravé de façon à simuler l'évent. Le trou présente un diamètre de 3 µm et une profondeur de 0,3 µm.

Un premier dépôt par évaporation d'aluminium (Al) à froid a été réalisé. Le substrat a été incliné de 45° par rapport au flux de vapeur pour faciliter le bouchage de l'évent. Un dépôt de 2,6 µm a été réalisé.

L'observation au microscope électronique à balayage montre que la couche d'aluminium n'a pas permis de combler l'évent (figure 2).

Un nouveau dépôt de 3 µm d'épaisseur, réalisé avec chauffage de l'échantillon et avec le porte-substrat incliné à 45° a été réalisé. L'échantillon a été porté à une température de 145°C pendant le dépôt. On se trouve ici dans des conditions optimales, telles que définies par l'homme de l'art, pour combler un évent avec ce type de procédé. Les analyses au MEB montrent que l'évent n'est cependant pas bouché (figure 3).

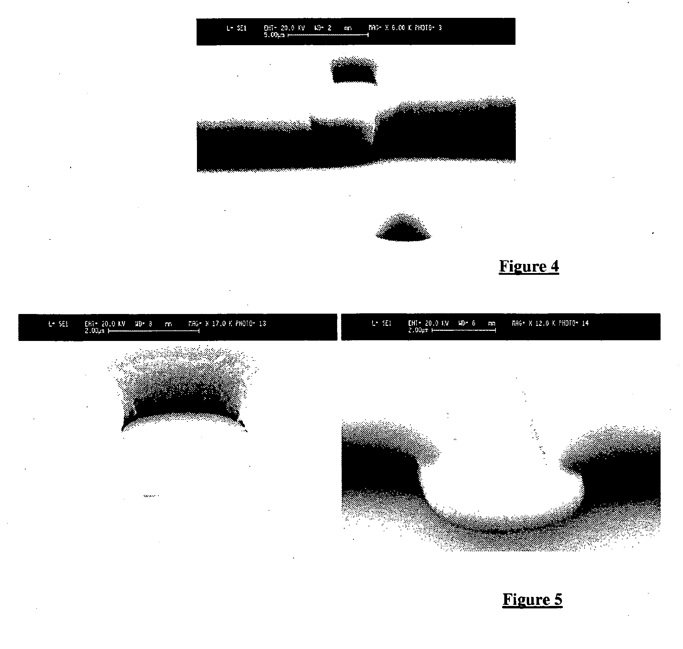

Un autre matériau, qui présente l'avantage d'être transparent dans la gamme infrarouge, à savoir le sulfure de zinc (ZnS), a été testé. Le dépôt a été conduit dans un évaporateur de type BALZERS BAK 760. Le porte-échantillon est constitué d'une calotte. L'image MEB montre que le bouchage d'évent n'a pas été obtenu (figure 4).

La figure 5 est une vue au microscope à balayage d'une coupe du dispositif déjà décrit après dépôt de Germanium. Le Germanium a été déposé dans les conditions décrites ci-dessus sur un bâti équivalent au modèle BALZERS BAK 760 avec un porte-substrat de type calotte.

L'épaisseur de germanium déposée ici est de 2 µm.

On peut observer sur la figure 5 que le dépôt est conforme et qu'il n'y a pas de discontinuité après le passage de marche. Le trou dans ce dispositif qui simule l'évent de microbolomètre est bouché.

### BIBLIOGRAPHIE

(1) H. Guckel and D.W. Burns, "Sealed cavity semiconductor pressure transducers and method of producing the same", US patent no. 4 853 669.
(2) B.H. Stark and K. Najafi, Journal of Microelectromechanical systems, Vol. 13, no. 2, April 2004.

## Revendications

1. Procédé de scellement d'une cavité d'un composant placé dans une enceinte par mise en oeuvre de la technologie du dépôt physique en phase vapeur (PVD), ***caractérisé* en ce que** le dépôt est réalisé par évaporation de Germanium ou de Silicium, et **en ce que** la température dans l'enceinte est inférieure à 100°C, avantageusement de l'ordre de 20°C.

2. Procédé de scellement d'une cavité d'un composant selon la revendication 1, ***caractérisé* en ce que** le composant ne subit aucun chauffage intentionnel.

3. Procédé de scellement d'une cavité d'un composant selon l'une des revendications précédentes, ***caractérisé* en ce que** le composant est placé sur un porte-échantillon de type calotte situé dans l'enceinte, ledit porte-échantillon étant avantageusement non incliné.

4. Procédé de scellement d'une cavité d'un composant selon l'une des revendications précédentes, ***caractérisé* en ce que** l'enceinte est constituée d'un bâti PVD d'évaporation standard.

5. Procédé de scellement d'une cavité d'un composant selon l'une des revendications précédentes, ***caractérisé* en ce que** la pression dans l'enceinte est comprise entre 10⁻⁵ Pa et 10⁻¹ Pa.

6. Procédé de scellement d'une cavité d'un composant selon la revendication 5, ***caractérisé* en ce que**, préalablement à l'évaporation, la pression dans l'enceinte est inférieure à 10⁻⁴ Pa.

7. Procédé de scellement d'une cavité d'un composant selon la revendication 5, ***caractérisé* en ce qu'**en l'absence de dégazage, la pression dans l'enceinte au moment du dépôt est comprise entre 10⁻⁴ Pa et 10⁻³ Pa.

8. Procédé de scellement d'une cavité d'un composant selon la revendication 5, ***caractérisé* en ce qu'**en présence d'au moins un gaz, la pression dans l'enceinte au moment du dépôt est de l'ordre de 10⁻¹ Pa.

9. Procédé de scellement d'une cavité d'un composant selon l'une des revendications précédentes, ***caractérisé* en ce que** le composant est réalisé en verre ou en polymère.

10. Procédé de scellement d'une cavité d'un composant selon l'une des revendications précédentes, ***caractérisé* en ce que** le composant est constitué d'un nano- ou micro-dispositif.

11. Procédé de scellement d'une cavité d'un composant selon la revendication 10, ***caractérisé* en ce que** le composant est constitué par un micro-bolomètre.

## Claims

1. Method for sealing a cavity of a component placed in a chamber by physical vapour deposition (PVD), ***characterized* in that** the deposition is carried out by evaporation of germanium or silicon, and **in that** the temperature in the chamber is lower than 100°C, advantageously about 20°C.

2. Method for sealing a cavity of a component according to Claim 1, ***characterized* in that** no intentional heating is carried out on the component.

3. Method for sealing a cavity of a component according to one of the preceding claims, ***characterized* in that** the component is placed on a shell type sample-holder located in the chamber, said holder being advantageously not inclined.

4. Method for sealing a cavity of a component according to one of the preceding claims, ***characterized* in that** the chamber consists of a standard evaporation PVD rack.

5. Method for sealing a cavity of a component according to one of the preceding claims, ***characterized* in that** the pressure in the chamber is between 10⁻⁵ Pa and 10⁻¹ Pa.

6. Method for sealing a cavity of a component according to Claim 5, ***characterized* in that**, prior to the evaporation, the pressure in the chamber is lower than 10⁻⁴ Pa.

7. Method for sealing a cavity of a component according to Claim 5, ***characterized* in that** in the absence of degassing, the pressure in the chamber at the time of deposition is between 10⁻⁴ Pa and 10⁻³ Pa.

8. Method for sealing a cavity of a component according to Claim 5, ***characterized* in that** in the presence of at least one gas, the pressure in the chamber at the time of deposition is about 10⁻¹ Pa.

9. Method for sealing a cavity of a component according to one of the preceding claims, ***characterized* in that** the component is made from glass or polymer.

10. Method for sealing a cavity of a component according to one of the preceding claims, ***characterized* in that** the component consists of a nano- or micro-device.

11. Method for sealing a cavity of a component according to Claim 10, ***characterized* in that** the component consists of a micro-bolometer.

## Patentansprüche

1. Verfahren zum Versiegeln eines Hohlraums eines in einer Kammer angeordneten Bauelements durch Anwendung der Technologie der physikalischen Abscheidung in der Dampfphase (PVD), **dadurch gekennzeichnet, dass** die Abscheidung durch Verdampfung von Germanium oder Silicium vorgenommen wird und dass die Temperatur in der Kammer weniger als 100°C, vorzugsweise etwa 20°C beträgt.

2. Verfahren zum Versiegeln eines Hohlraums eines Bauelements nach Anspruch 1, **dadurch gekennzeichnet, dass** das Bauelement keiner absichtlichen Erwärmung unterzogen wird.

3. Verfahren zum Versiegeln eines Hohlraums eines Bauelements nach einem der vorhergehenden Ansprüche, **dadurch gekennzeichnet, dass** das Bauelement auf einen in der Kammer befindlichen Probenhalter vom Typ Kalotte gesetzt wird, der vorteilhafterweise nicht geneigt ist.

4. Verfahren zum Versiegeln eines Hohlraums eines Bauelements nach einem der vorhergehenden Ansprüche, **dadurch gekennzeichnet, dass** die Kammer aus einem Standard-PVD-Verdampfungsgestell besteht.

5. Verfahren zum Versiegeln eines Hohlraums eines Bauelements nach einem der vorhergehenden Ansprüche, **dadurch gekennzeichnet, dass** der Druck in der Kammer zwischen 10⁻⁵ Pa und 10⁻¹ Pa beträgt.

6. Verfahren zum Versiegeln eines Hohlraums eines Bauelements nach Anspruch 5, **dadurch gekennzeichnet, dass** der Druck in der Kammer vor der Verdampfung weniger als 10⁻⁴ Pa beträgt.

7. Verfahren zum Versiegeln eines Hohlraums eines Bauelements nach Anspruch 5, **dadurch gekennzeichnet, dass** bei Fehlen einer Entgasung der Druck in der Kammer zum Zeitpunkt der Abscheidung zwischen 10⁻⁴ und 10⁻³ Pa beträgt.

8. Verfahren zum Versiegeln eines Hohlraums eines Bauelements nach Anspruch 5, **dadurch gekennzeichnet, dass** bei Vorhandensein mindestens eines Gases der Druck in der Kammer zum Zeitpunkt der Abscheidung etwa 10⁻¹ Pa beträgt.

9. Verfahren zum Versiegeln eines Hohlraums eines Bauelements nach einem der vorhergehenden Ansprüche, **dadurch gekennzeichnet, dass** das Bauelement aus Glas oder aus Polymer hergestellt ist.

10. Verfahren zum Versiegeln eines Hohlraums eines Bauelements nach einem der vorhergehenden Ansprüche, **dadurch gekennzeichnet, dass** das Bauelement aus einer Nano- oder Mikrovorrichtung besteht.

11. Verfahren zum Versiegeln eines Hohlraums eines Bauelements nach Anspruch 10, **dadurch gekennzeichnet, dass** das Bauelement aus einem Mikrobolometer besteht.
